Europäisches Patentamt

European Patent Office

Office européen des brevets

(11) Veröffentlichungsnummer: **0 328 952**
**A1**

## (12) EUROPÄISCHE PATENTANMELDUNG

(21) Anmeldenummer: **89101821.0**

(22) Anmeldetag: **02.02.89**

(51) Int. Cl.4: **H05K 9/00 , E06B 5/18**

(30) Priorität: **15.02.88 DE 3804606**

(43) Veröffentlichungstag der Anmeldung:
**23.08.89 Patentblatt 89/34**

(84) Benannte Vertragsstaaten:
**AT BE CH DE FR GB IT LI NL SE**

(71) Anmelder: **Siemens Aktiengesellschaft**
**Wittelsbacherplatz 2**
**D-8000 München 2(DE)**

(72) Erfinder: **Kohlbrenner, Walter**
**Amselweg 61**
**D-8510 Fürth(DE)**
Erfinder: **Schaller, Rudolf, Dipl.-Ing. (FH)**
**Südring 17**
**D-8401 Alteglofsheim(DE)**
Erfinder: **Wäger, Johann, Dipl.-Ing. (FH)**
**Birkensteige 6**
**D-8535 Emskirchen(DE)**

(54) **Elektromagnetisch abgeschirmtes und thermisch isoliertes Fenster aus einem Glasverbundelement mit Halterungsträger.**

(57) Ein Glasverbundelement (1) besteht aus mindestens zwei Verbundglasscheiben (2,8), welche einen gasdichten Hohlraum (6) bildend mittels eines wärmeisolierenden Abstandselementes (7) fest miteinander verbunden sind. In jede der Verbundglasscheiben (2,8) ist ein Metallmaschengewebe mit jeweils über den Glaskörper überstehenden Rändern (11,12) einlaminiert. Ein Träger zur Halterung eines derartigen Glasverbundelementes besteht aus einem Montagerahmen (27), einem Schirmrahmen (26,40,50), einem Außenrahmen (48,48a,21a, 22a,23a, 48b,21b,22b,23b) und einem Spannrahmen (35,41). Dieser Träger kann feststehend bzw. zu öffnend ausgeführt sein. Bei der zu öffnenden Ausführung ist der Außenrahmen und der Schirmrahmen geteilt. So bilden der Montagerahmen (27), der feststehende Teil des Außenrahmens (48b,21b,22b,23b) und der feststehende Schirmrahmenteil (40) eine Zarge, und der bewegliche Außenrahmenteil (48a,21a,22a,23a), der bewegliche Schirmrahmenteil (50) und der Spannrahmen (41) einen Flügel.

FIG 5

## Elektromagnetisch abgeschirmtes und thermisch isoliertes Fenster aus einem Glasverbundelement mit Halterungsträger

Die Erfindung betrifft ein Glasverbundelement für ein elektromagnetisch abgeschirmtes und thermisch isoliertes Fenster gemäß dem Oberbegriff von Anspruch 1. Die Erfindung betrifft ferner einen Träger zur Halterung eines solchen Glasverbundelementes.

Aus dem Siemens Datenbuch "EMV Raumabschirmung, Kabinen, Bau teile, Filter, Ausgabe 1983/84, Seite 190-195 ist es bekannt, zur gleichzeitigen elektromagnetischen Abschirmung und thermischen Isolation von Fensteröffnungen, insbesondere in Gebäuden und Kabinen, die Kombination von einem Glasfenster mit einem sogenannten "Wabenkamineinsatz" zu verwenden. Solche Wabenkamineinsätze bestehen aus einer Vielzahl kleiner Hohlleiter, welche unterhalb einer von deren geometrischen Abmessungen abhängigen Grenzfrequenz dämpfend auf einfallende elektromagnetische Abstrahlungen wirken. Die einzelnen Hohlleiter haben dabei eine solche Größe, daß in der Regel ein ausreichender Lichtdurchtritt durch den Wabenkamineinsatz möglich ist. Zur thermischen und elektromagnetischen Abdichtung wird somit die jeweilige Fensteröffnung mit einem konventionellen Glasfenster und einem zusätzlichen auf der Fensteraußen- bzw. Innenseite angebrachten Wabenkaminfenster verschlossen. Eine derartige Ausführung hat den Nachteil, daß die Fensteröffnung zur Aufnahme der beiden getrennten Fenster geeignet bzw. in der Regel durch zusätzliche bauseitige Maßnahmen erst vorbereitet werden muß. Häufig ist es notwendig insbesondere durch zusätzliche Aufmauerungen für eine zur Aufnahme der beiden Fenster ausreichende Tiefe der abzuschließenden Fensteröffnung zu sorgen. Falls dies nicht möglich ist, muß eine vollständige, vom Fußboden bis zur Decke des Raumes reichende Wabenkaminwand auf der Innenseite des abzuschirmenden Glasfensters angebracht werden. Aus der DE-PS 29 46 519 ist desweiteren ein Fenster mit elektromagnetischer und akustischer Abschirmung bekannt. Zur elektromagnetischen Abschirmung dient dabei eine die Fensteraußenseite bildende und auf ihrer Innenseite mit Gold bedampfte erste Scheibe, und eine die Fensterinnenseite bildende, mit einem Metalldrahtgewebe belegte weitere Scheibe. In dem durch diese beiden Scheiben gebildeten Hohlraum ist zur akustischen Abschirmung des Fensters eine zweite Scheibe unter Bildung je eines Luftpolsters zur Fensteraußen- und Innenscheibe angeordnet. Die Goldbedampfung der Außenscheibe und das Metalldrahtgewebe der Innenscheibe sind elektrisch leitend mit der elektromagnetischen Abschirmung der die Fensteröffnung umgebenden Wand verbunden. Zur Verbesserung der Wirkung der elektromagnetischen Abschirmung können auf der Fensterinnenseite weitere mit Metalldrahtgewebe belegte Scheiben aufgesetzt werden. Ein derartiges Fenster hat den Nachteil, daß es aus einer Vielzahl unterschiedlicher Scheiben besteht, welche am Einbauort in einer fest vorgegebenen Reihenfolge separat in die Fensteröffnung eingepaßt werden müssen. Der Montageaufwand wird weiterhin dadurch erhöht, daß das Metalldrahtgewebe bzw. eine transparente Kunststoffolie mit eingeschmolzenem Metalldrahtgewebe zwischen einzelnen, als Abstützung dienenden Scheiben einzuklemmen ist. Der DE-PS 29 46 519 sind keine Hinweise darauf zu entnehmen, wie das dort beschriebene und aus einer bestimmten Anordnung einzelner Scheiben bestehende "Fenster" in einer bauseitigen Fensteröffnung mechanisch, z.B. in einem Rahmen, zu befestigen ist.

Der vorliegenden Erfindung liegt die Aufgabe zugrunde, ein komplett einbaufähiges, elektromagnetisch abgeschirmtes und thermisch isoliertes Fenster anzugeben.

Die Aufgabe wird gelöst durch die kennzeichnenden Merkmale von Anspruch 1. Der nebengeordnete Anspruch 9 betrifft einen Träger zur Halterung des erfindungsgemäßen Fensters. Vorteilhafte Ausführungsformen von Fenster und Träger sind in den Unteransprüchen angegeben. Die Erfindung wird desweiteren anhand der nachfolgend kurz angeführten Figuren näher erläutert. Dabei zeigt:

FIG 1 den Grundaufbau eines Glasverbundelementes gemäß der Erfindung,

FIG 2 eine weitere Ausführungsform des Glasverbundelementes mit aufgedoppelter Panzerglasscheibe,

FIG 3 eine weitere Ausführungsform des Glasverbundelementes mit einer zusätzlichen, einen weiteren Hohlraum bildenden Verbundglasscheibe,

FIG 4 eine weitere Ausführungsform des Glasverbundelementes mit einer zusätzlichen, direkt aufgedoppelten Verbundglasscheibe,

FIG 5 einen feststehenden Träger zur Halterung eines elektromagnetisch abgeschirmten und thermisch isolierten Glasverbundelementes, und

FIG 6 eine aus einem feststehenden Rahmen und einen beweglichen Flügel bestehende weitere Ausführungsform des erfindungsgemäßen Trägers.

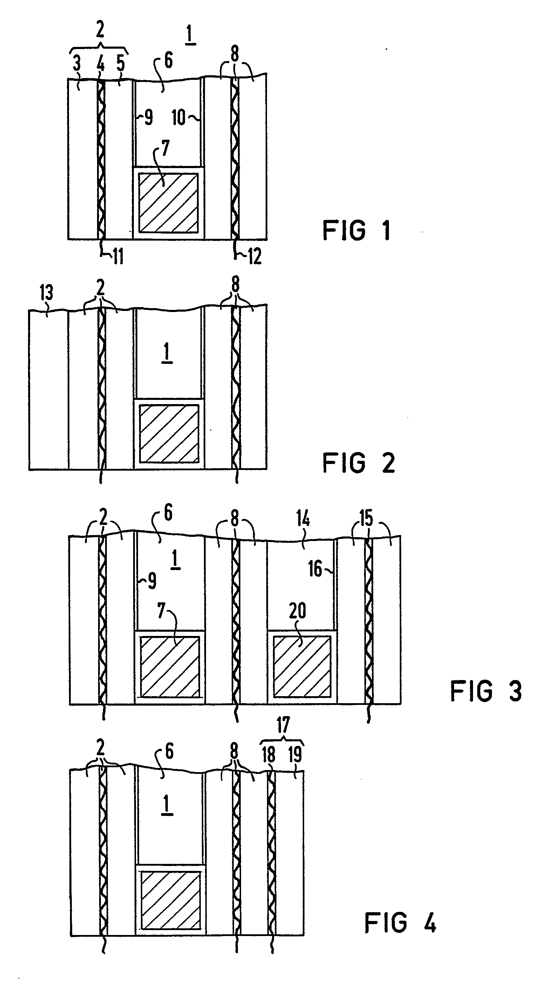

In der FIG 1 ist das erfindungsgemäße Glasverbundelement 1 im Schnitt dargestellt. Es besteht aus zwei elektromagnetisch abschirmenden Verbundglasscheiben 2 bzw. 8, welche einen gasdicht abgeschlossenen Hohlraum 6 bildend über ein rahmenförmig umlaufendes, wärmeisolierendes Abstandselement 7 fest miteinander verbunden sind. Zur Erhöhung der wärmeisolierenden Eigenschaften dieses Glasverbundelementes ist es in weiteren Ausgestaltungen der Erfindung vorteilhaft, den Hohlraum 6 mit Wärmeschutzgas zu füllen, bzw. eine oder beide insbesondere der dem Hohlraum zugewandten Flächen 9 bzw. 10 der Verbundglasscheibe 2 bzw. 8 mit einer Wärmeschutzbeschichtung zu versehen. Abhängig davon, welche der beiden Verbundglasscheiben 2 bzw. 8 der Fensteraußen- bzw. der Innenseite zugewandt ist, wirkt die dazugehörige Wärmeschutzbeschichtung 9 bzw. 11 als eine Sonnenschutzbeschichtung gegen den Einfall athmosphärischer Wärmestrahlung bzw. als eine Wärmeschutzbeschichtung gegen die Abstrahlung von Wärme aus dem Innenraum.

Zur elektromagnetischen Abschirmung ist in den Glaskörper einer jeden Verbundglasscheibe 2 bzw. 8 ein Metallmaschengewebe 4 eingelassen. Zur elektrischen Kontaktierung des jeweiligen Me-tallmaschengewebes mit den das Glasverbundele-ment 1 umgebenden weiteren Abschirmeinrichtun-gen steht die jeweilige Gewebebahn in einem Randbereich 11 bzw. 12 aus dem eigentlichen Glaskörper heraus. Die Einlaminierung dieses Metallmaschengewebes zur Bildung einer kompakten Verbundglasscheibe kann dabei auf unterschiedliche Weise erfolgen. Zum einen können z.B. zur Bildung der Verbundglasscheibe 2 in der FIG 1 zwei separate Glasscheiben 3 und 5 dienen, welche z.B. mittels eines hochtransparenten, sonnenlichtbeständigen Kunstharzes bzw. Kunststoffglases unter Einschluß des Metallmaschengewebes 4 miteinander verklebt sind. In einer anderen Ausführungsform der Verbundglasscheibe kann das Metallmaschengewebe 4 beim Herstellungsprozeß auch direkt in die Glasschmelze eingebracht werden, so daß ein ausschließlich aus Glas und Metall bestehender Verbundglaskörper entsteht.

Es ist ein besonderer Vorteil des erfindungsgemäßen Glasverbundelementes, daß es in einbaureifer Form vorgefertigt werden kann. Der Einbau wird weiter dadurch erleichtert, daß das erfindungs-mäße Glasverbundelement weder im Hinblick auf die elektromagnetische Abschirmung noch auf die thermische Isolation eine Vorzugsrichtung aufweist. Bei dem Glasverbundelement der FIG 1 kann somit sowohl die Verbundglasscheibe 2 als auch die Verbundglasscheibe 8 als Innen- bzw. Außenscheibe verwendet werden.

In den FIG 2 bis 4 sind weitere vorteilhafte Ausführungsformen der Erfindung dargestellt. Der Grundkörper des erfindungsgemäßen Glasverbundelementes gemäß der FIG 1 ist dabei um zusätzliche Glaselemente ergänzt. So ist es z.B. zur Erhöhung der Durchschußsicherheit vorteilhaft, das Glasverbundelement durch zusätzliche Panzerglasscheiben auf einer oder beiden Außenseiten abzusichern. So ist in der Ausführungsform gemäß der FIG 2 eine Panzerglasscheibe 13 auf der Verbundglasscheibe 2 des Glasverbundelementes 1 aufgedoppelt. Auch hier ist es aus montagetechnischen Gründen besonders vorteilhaft, wenn die Panzerglasscheibe z.B. durch Verklebung fest mit dem Glasverbundelement 1 verbunden ist.

Zur weiteren Verbesserung der elektromagnetischen Abschirmung und der thermischen Isolation des erfindungsgemäßen Glasverbundelementes ist es in weiteren Ausgestaltungen besonders vorteilhaft, dieses mit weiteren Verbundglasscheiben zu kombinieren. So ist in der Ausführungsform gemäß der FIG 3 eine weitere elektromagnetisch abschirmende Verbundglasscheibe 15 unter Bildung eines weiteren Hohlraumes 14 mit Hilfe eines weiteren wärmeisolierenden Abstandselementes 20 auf das aus den Verbundglasscheiben 2 und 8 bestehende Glasverbundelement 1 aufgedoppelt. Auch hier ist es insbesondere aus montagetechnischen Gründen besonders vorteilhaft, wenn alle drei Verbundglasscheiben 2,8,15 fest miteinander zu einem kompakten Glasverbundelement verbunden sind. Es ist ein besonderer Vorteil der Erfindung, das die gewünschte Güte der vom jeweiligen Einbauort abhängigen elektromagnetischen Abschirmung und thermischen Isolation auf besonders einfache Weise durch Hinzufügen von weiteren Grundbauelementen des Glasverbundelementes erreicht werden kann. So sind das wärmeisolierende Abstandselement und die elektromagnetisch abschirmende Verbundglasscheibe die beiden einzigen Grund-bauelemente des erfindungsgemäßen Glasverbund-elementes. Durch Hinzufügen eines oder mehrerer dieser Grundbauelemente zum Glasverbundelement 1 können dessen abschirmende und isolierende Eigenschaften besonders einfach eingestellt werden. In der in der FIG 3 dargestellten Ausführungsform der Erfindung sind beispielsweise nur die dem jeweiligen Hohlraum zugewandten Innenseiten der beiden Verbundglasscheiben 8 und 15, welche die Außenseiten des Glasverbundelementes bilden, mit je einer Wärmeschutzbeschichtung 9 bzw. 16 versehen. Falls in einer Anwendung des Glasverbundelementes besonders hohe Anforderungen an dessen elektromagnetisch abschirmende Eigenschaften gestellt werden, so ist es in einer weiteren Ausführungsform der Erfindung ohne weiteres möglich, z.B. die Verbundglasscheibe 15 ohne Bildung eines Hohlraumes auch direkt auf eine der beiden Verbundglasscheiben 2 bzw. 8 des Glasverbundelementes aufzudoppeln. In der FIG 4 ist eine besondere Ausgestaltung dieses Prinzips dargestellt. Dabei besteht die die rechte Außenseite des Glasverbundelementes 1 bildende Verbundglasscheibe aus einem sogenannten Doppelverbund mit zwei eingelegten Metallmaschengeweben. Auch hier ist es besonders vorteilhaft, wenn die zusätzliche Glasscheibe 19 und das zusätzliche Metallmaschengewebe 18 z.B. durch Verklebung fest mit den übrigen Elementen der Scheibe verbunden ist.

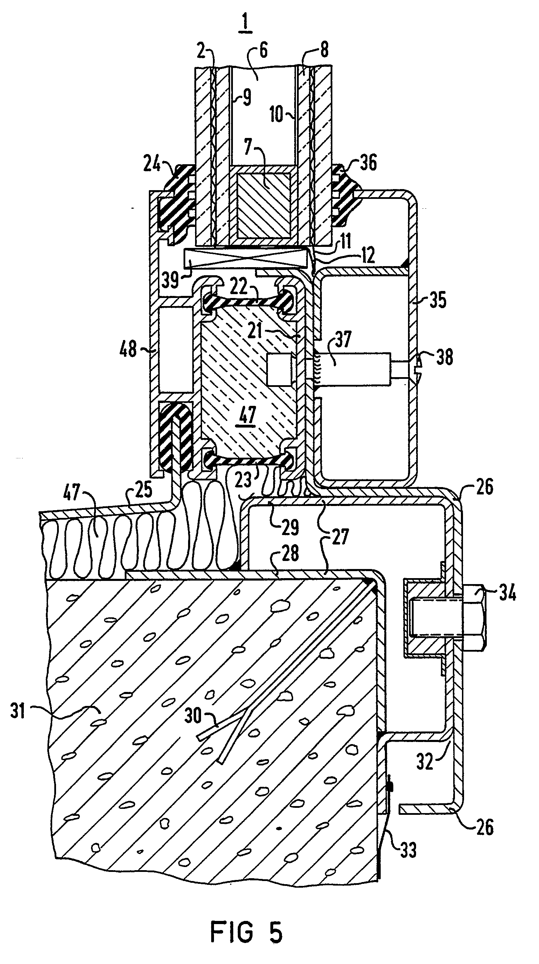

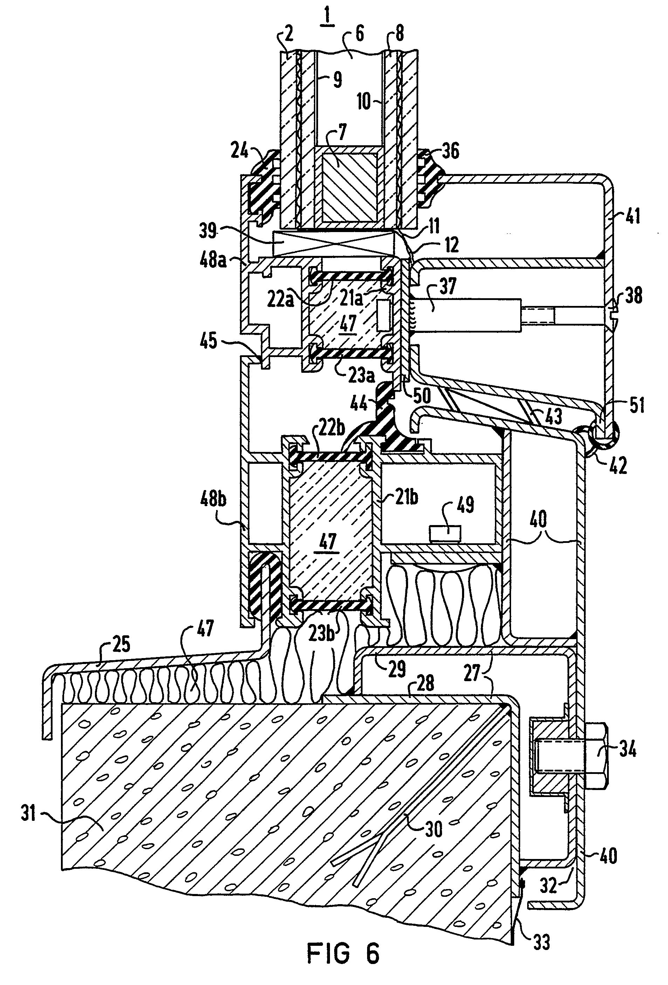

In den FIG 5 und 6 ist je eine besonders vorteilhafte Ausführungsform eines Trägers zur Halterung eines elektromagnetisch abgeschirmten und thermisch isolierten Glasverbundelementes dargestellt. Dabei ist der Einfachheit halber ein Glasverbundelement 1 gemäß der Ausführungsform von FIG 1 als Trägerelement ausgewählt. Selbstverständlich kann auch jede andere der oben dargestellten Ausführungsformen des erfindungsgemäßen Glasverbundelementes vom Träger gehaltert werden. Dieser besteht erfindungsgemäß aus einem Montagerahmen, einem Schirmrahmen, einem Außenrahmen und einem Spannrahmen als Grundbauelemente. Die FIG 5 zeigt den erfindungsgemäßen Träger in einer feststehenden, und die FIG 6 in einer zu öffnenden Außführungsform.

Der Montagerahmen 27 ist bei der feststehenden und der zu öffnenden Ausführungsform des Trägers gemäß den Darstellungen in FIG 5 und FIG 6 vollkommen identisch. Er besteht jeweils aus einem im Mauerwerk 31 eingelassenen Maueranker 30, einem daran befestigten und an der abzudichtenden Fensteröffnung anliegenden Mauerwinkel 28 und einem insbesondere durch Verschweißen mit dem Mauerwinkel verbundenen Befestigungswinkel 29. Der Montagerahmen dient zur Abstützung des Trägers und des davon gehalterten Glas-Glasverbundelementes in der bauseitigen Fensteröffnung. Mit diesem Montagerahmen ist ein Schirmrahmen elektrisch leitend und mechanisch fest verbunden, z.B. mittels schraubenförmiger Befestigungselemente 34.

In der feststehenden Ausführungsform des Trägers gemäß der Darstellung von FIG 5 deckt dieser Schirmrahmen 26 den verbleibenden Spalt zwischen Mauerwerk 31 und Glasverbundelement 1 nahezu vollständig ab. Die durchgehende elektromagnetische Abschirmung der Fensteröffnung wird zum einen erfindungsgemäß dadurch bewirkt, daß die aus dem Glasverbundelement 1 überstehenden Ränder 1 bzw. 12 der Verbundglasscheiben 2 bzw. 8 mit dem Schirmrahmen 26 elektrisch leitend kontaktiert sind. Zum anderen ist das Metallmaschengewebe über den Schirmrahmen und den Mauerrahmen mittels einer zusätzlichen leitenden Verbindung 33 mit der übrigen Gebäude-, Raum-, bzw. Kabinenschirmung verbunden.

Ein insbesondere aus den Elementen 48,21,22 und 23 bestehender Außenrahmen stützt zum einen das Glasverbundelement insbesondere über eine Gummidichtung 24 mechanisch so ab, daß es gegen Herausfallen nach außen gesichert ist. Zum anderen wird mit Hilfe des Außenrahmens die thermische Isolation des erfindungsgemäßen Trägers bewirkt. Hierzu dienen wärmeisolierende, insbesondere aus Gummi bzw. Kunststoff gefertigte Abstandshalter 22 und 23, welche das Außenrahmenaußenteil 48 und das Außenrahmengegenstück 21 thermisch getrennt unter Vermeidung von Wärmebrücken mechanisch miteinander verbinden. Das Außenrahmengegenstück 21 ist vorteilhaft über Schraub- bzw. Nietverbindungen mechanisch mit dem Schirmrahmen 26 verbunden. Es ist besonders vorteilhaft, wenn der durch das Außenrahmenaußenteil, das Außenrahmengegenstück und die beiden Abstandshalter gebildete Hohlraum mit einer Wärmeisolierung 47 ausgefüllt ist. Desweiteren ist es besonders vorteilhaft, wenn das Außenrahmenaußenteil 48 gleichzeitig zur Halterung eines Fensterbrettes 25 auf der Fensteraußenseite dient. Auch hier ist der zwischen dem Fensterbrett und dem Mauerwerk 31 bzw. dem Mauerwinkel 27 gebildete Hohlraum vorteilhaft mit Wärmeisolationsmaterial 47 ausgefüllt.

In einer weiteren Ausführungsform ist es vorteilhaft, wenn das Glasverbundelement 1 verspannungsfrei über ein insbesondere wärmeisolierendes und bis zu einem gewissen Grad elastisches Lager 39 über den Spannrahmen 26 und den Mauerrahmen 27 abgestützt wird.

Schließlich dient ein Spannrahmen 35, welcher mechanisch insbesondere über den Schirmrahmen 26 mit dem Außenrahmengegenstück 21 verbunden ist, bevorzugt über eine Gummidichtung 36 zur Abstützung und Absicherung des Glasverbundelementes 1 gegen Herausfallen nach innen. In einer besonders vorteilhaften Ausführungsform der Erfindung wird die Kontaktierung des überstehenden Metallmaschengewebes 11,12 mit dem Schirmrahmen 26 dadurch bewerkstelligt, daß das Maschengewebe zwischen dem Schirmrahmen 26 und dem insbesondere über Schraubelemente 38 befestigten Spannrahmen 35 verklemmt wird. Es ist ein besonderer Vorteil des erfindungsgemäßen Trägers, daß das Glasverbundelement 1 bereits nach Entfernen des Spannrahmens 35 mechanisch und elektrisch vom Träger so losgelöst ist, daß es herausgenommen werden kann. Bei einem Austausch des Glasverbundelementes sind somit keinerlei Eingriffe in die thermische Isolation des Trägers notwendig.

In der FIG 6 ist die zu öffnende Ausführungsform des erfindungsgemäßen Trägers dargestellt. Hierbei ist der Außenrahmen und der Schirmrahmen in einen feststehenden und einen beweglichen Teil aufgeteilt. So bilden das Außenrahmenaußenteil 48b, das Außenrahmengegenstückteil 21b, die dazugehörigen wärmeisolierenden Abstandshalter 22b,23b und der Schirmrahmenteil 40 den feststehenden, eine Zarge bzw. einen Rahmen darstellenden Teil des erfindungsgemäßen Trägers. Entsprechend bilden das Außenrahmenaußenteil 48a, das Außenrahmengegenstückteil 2la, die dazugehörigen wärmeisolierenden Abstandshalter 22a,23a und das Schirmrahmenteil 50 den beweglichen, einen Flügel darstellenden Teil des erfindungsgemäßen Trägers. Auf diesem Flügel befindet sich auch der Spannrahmen 41, welcher besonders vorteilhaft mittels schraubenförmiger Verbindungselemente 38 über das bewegliche Teil 50 des Schirmrahmens mit dem beweglichen Teil 21a des Außenrahmengegenstückes verbunden ist. Auch hier dient der Spannrahmen sowohl zur mechanischen Abstützung des Glasverbundelementes 1 auf der Innenseite als auch zur elektrisch leitenden Verklemmung der überstehenden Metallmaschengewebe 11,12 mit dem Schirmrahmenteil 50. Zur vollständigen elektromagentischen Abschirmung des Trägers im geschlossenen Zustand des Flügels dient gemäß der Ausführungsform von FIG 6 ein zwischen dem Spannrahmen 41 und dem feststehenden Schirmrahmenteil 40 befindliches Kontaktelement 43, welches bevorzugt in Form einer umlaufenden, hochfrequenzdichten Kontaktfeder ausgeführt ist. In einer anderen, nicht dargestellten Ausführungsform der Erfindung ist es auch möglich, die hochfrequenzdichte, elektrisch leitende Kontaktierung zwischen dem beweglichen Flügel und der feststehenden Zarge durch ein entsprechend ausgebildetes und das feststehende Schirmrahmenteil 40 direkt mit dem beweglichen Schirmrahmenteil 50 kontaktierenden Verbindungselement herzustellen.

Zur wärmetechnischen Isolierung der Öffnung zwischen Flügel und Zarge ist es vorteilhaft, eine umlaufende Gummidichtung 44 vorzusehen, welche bevorzugt zwischen dem feststehenden Außenrahmengegenstück 21b und dem beweglichen Außenrahmengegenstück 2la angeordnet ist. Desweiteren ist es vorteilhaft, den in der Zarge durch das feststehende Außenrahmenaußenteil 48b, das Außenrahmengegenstückteil 21b und die beiden dazugehörigen wärmeisolierenden Abstandshalter 22b,23b gebildeten Hohlraum, bzw. den im Flügel durch das bewegliche Außenrahmenaußenteil 48a, das Außenrahmengegenstück 21a und die beiden dazugehörigen wärmeisolierenden Abstandshalter 22a,23a gebildeten Hohlraum mit Wärmeisolationsmaterial 47 auszufüllen. Aufgrund dieser Wärmeisolierung ist es nicht unbedingt notwendig, die Stoßstelle 45 zwischen dem feststehenden Außenrahmenaußenteil 48b und dem beweglichen Außenrahmenaußenteil 48a zusätzlich thermisch abzudichten. Bei Bedarf kann auf der Fensterinnenseite eine Gummidichtung 42 zwischen einer vom Spannrahmen 41 überstehenden Nase 51 und dem feststehenden Schirmrahmenteil 40 vorgesehen werden.

**Ansprüche**

1. Glasverbundelement für ein elektromagnetisch abgeschirmtes und thermisch isoliertes Fenster, **gekennzeichnet** durch

a) eine erste und eine zweite Verbundglasscheibe (2,8) mit einem jeweils im Glaskörper befindlichen, überstehenden Metallmaschengewebe (4), und

b) ein wärmeisolierendes, rahmenförmiges Abstandselement (7), mit dem die beiden Verbundglasscheiben einen gasdicht abgeschlossenen Hohlraum (6) bildend verbunden sind.

2. Glasverbundelement mit einer Verbundglasscheibe (2) nach Anspruch 1, **dadurch gekennzeichnet,** daß zwei Glasscheiben (3,5) mittels eines dazwischen einlaminierten, überstehenden Metallmaschengewebes (4) fest miteinander verbunden sind.

3. Glasverbundelement mit einer Verbundglasscheibe nach Anspruch 1, **dadurch gekennzeichnet** daß das Metallmaschengewebe in den Glaskörper eingeschmolzen ist.

4. Glasverbundelement nach einem der vorangegangenen Ansprüche, **gekennzeichnet** durch Wärme- und/oder Sonnenschutzbeschichtungen (9,10) insbesondere auf den Flächen der Verbundglasscheiben, welche dem Hohlraum (6) zugewandt sind (FIG 1).

5. Glasverbundelement nach einem der vorangegangenen Ansprüche **gekennzeichnet** durch mindestens eine weitere Verbundglasscheibe (15), welche mindestens einen weiteren Hohlraum (14) bildend mittels eines weiteren wärmeisolierenden Abstandselementes (20) mit dem Glasverbundelement verbunden ist (FIG 3).

6. Glasverbundelement nach einem der vorangegangenen Ansprüche **gekennzeichnet** durch eine Verbundglasscheibe (8,18,19) aus einem Doppelverbund mit zwei im Glaskörper befindlichen Lagen von Metallmaschengewebe (FIG 4).

7. Glasverbundelement nach einem der vorangegangenen Ansprüche, **gekennzeichnet** durch mindestens eine Panzerglasscheibe (l3), welche direkt auf eine der Außenflächen des Glasverbundelementes aufgedoppelt ist (FIG 2).

8. Glasverbundelement nach einem der vorangegangenen Ansprüche, **gekennzeichnet** durch Wärmeschutzgas in den Hohlräumen zwischen den Verbundglasscheiben.

9. Träger zur Halterung eines elektromagnetisch abgeschirmten und thermisch isolierten Glasverbundelementes mit überstehendem Metallmaschengewebe, **gekennzeichnet** durch

a) einen Montagerahmen (27,28,29,30) zur Befestigung des Trägers in der bauseitigen Fensteröffnung,

b) einen Schirmrahmen (26,40,50), welcher mechanisch mit dem Montagerahmen, und elektrisch leitend mit dem Montagerahmen und den aus dem Glasverbundelement (1) überstehenden Metallmaschengeweben (11,12) so verbunden ist, daß die bauseitige Fensteröffnung vollständig elektromagnetisch abgeschirmt ist,

c) einen Außenrahmen (48,22,23,21,48a,22a,23a,21a,48b,22b,23b, 21b), welcher das Glasverbundelement (1) auf der Außenseite gegen Herausfallen abstützt, die bauseitige Fensteröffnung thermisch isoliert und mechanisch mit dem Montagerahmen insbesondere über den Schirmrahmen verbunden ist, und

d) einen Spannrahmen (35,41,51), welcher elektrisch leitend mit dem Schirmrahmen und mechanisch mit dem Außenrahmen verbunden ist, und das Glasverbundelement (1) auf der Innenseite gegen Herausfallen abstützt.

10. Träger nach Anspruch 9, **gekennzeichnet** durch eine elektrisch leitende Kontaktierung (33) des Montagerahmens (27) mit einer Kabinen- bzw. Gebäudeschirmung.

11. Träger nach Anspruch 9 oder 10, **dadurch gekennzeichnet,** daß das überstehende Metallmaschengewebe (11,12) elektrisch leitend zwischen Schirm- und Spannrahmen verklemmt ist.

12. Träger mit einem Außenrahmen nach einem der Ansprüche 9 bis 11, **gekennzeichnet** durch ein Gegenstück (21, 21a,21b), welches mit dem Schirmrahmen (26,40,50) und über wärmeisolierende Abstandshalter (22,23,22a,23a,22b,23b) mit einem die Außenseite des Glasverbundelementes (1) abstützenden Außenteil (48,48a,48b) verbunden ist.

13. Träger nach Anspruch 12, **dadurch gekennzeichnet,** daß ein durch das Außenrahmengegenstück, das Außenrahmenaußenteil und die Abstandshalter gebildeter Hohlraum mit Wärmeisolationsmaterial (47) gefüllt ist (FIG 5).

14. Träger zur beweglichen Halterung eines elektromagnetisch abgeschirmten und thermisch isolierten Glasverbundelementes nach einem der Ansprüche 9 bis 13, **dadurch gekennzeichnet,** daß

a) der Außenrahmen geteilt ist in einen mit dem Montagerahmen (27,28,29,30) fest verbundenen, eine Zarge bildenden Teil (48b,22b,23b,21b), und in einen daran insbesondere drehbar gelagerten, das Glasverbundelement (1) abstützenden und einen Flügel bildenden Teil (48a,22a,23a,21a),

b) der Schirmrahmen geteilt ist in einen mit dem Montagerahmen elektrisch und mechanisch verbundenen, die Zarge bildenden Teil (40), und in einen elektrisch und mechanisch mit dem Metallmaschengewebe (11,12) des Glasverbundelementes (1) und dem Spannrahmen (41,51) verbundenen, den Flügel bildenden Teil (50), und

c) die beiden Teile des Schirmrahmens im geschlossenen Zustand des Flügels elektrisch miteinander kontaktiert sind.

15. Träger nach Anspruch 14, **gekennzeichnet** durch eine umlaufende, hochfrequenzdichte Kontaktfeder (43), welche im geschlossenen Zustand des Flügels den feststehenden Teil (40) des Schirmrahmens mit dem Spannrahmen (41) elektrisch kontaktiert (FIG 6).

88 P 3038

FIG 1

FIG 2

FIG 3

FIG 4

88 P 3038

FIG 5

88 P 3038

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| | Keine Entgegenhaltungen.<br>----- | | H 05 K 9/00<br>E 06 B 5/18 |
| | | | **RECHERCHIERTE SACHGEBIETE (Int. Cl.4)**<br><br>H 05 K<br>H 05 B<br>E 06 B |

**Der vorliegende Recherchenbericht wurde für alle Patentansprüche erstellt**

| Recherchenort | Abschlußdatum der Recherche | Prüfer |
|---|---|---|
| DEN HAAG | 17-03-1989 | TOUSSAINT F.M.A. |